Europäisches Patentamt

(19) European Patent Office

Office européen des brevets

(11) Publication number: **0 263 675**
**A2**

## (12) EUROPEAN PATENT APPLICATION

(21) Application number: **87308836.3**

(22) Date of filing: **06.10.87**

(51) Int. Cl.4: **H 01 B 1/16**

(30) Priority: **06.10.86 US 915850**

(43) Date of publication of application:
**13.04.88 Bulletin 88/15**

(84) Designated Contracting States:
**AT BE CH DE ES FR GB GR IT LI LU NL SE**

(71) Applicant: **ENGELHARD CORPORATION**
**Menlo Park, CN 40**
**Edison New Jersey 08818 (US)**

(72) Inventor: **Hsu, King F.**
**29 Oak Hill Drive**
**Wayne New Jersey 07470 (US)**

**Twerski, Isaac M.**
**1609 46th Street**
**Brooklyn New York 11204 (US)**

**Castillo, Imelda L.**
**3 Barclay Court**
**Somerset New Jersey 08873 (US)**

(74) Representative: **Fisher, Adrian John et al**
**CARPMAELS & RANSFORD 43 Bloomsbury Square**
**London WC1A 2RA (GB)**

(54) **Gold conductor composition.**

(57) A thick film gold conductor composition containing a small amount of silver/copper in a particular ratio and having superior aluminum wire bondability properties is disclosed.

EP 0 263 675 A2

**Description**

GOLD CONDUCTOR COMPOSITION

BACKGROUND OF THE INVENTION

Field Of The Invention

The present invention is directed to a thick film gold conductor composition for use in electronic microcircuits, including multilayer hybrid circuits. The thick film gold conductor composition of the present invention is particularly useful in applications wherein it is necessary to bond aluminum wires to metallized substrates and metallized dielectrics because of its excellent aluminum wire bondability properties and its resistance to aging especially on dielectrics.

Description Of The Prior Art

Integrated circuits require the use of very fine wires to connect active devices to thick film metallized substrates. Generally, the thin wires are attached to the active devices and to the metallized surfaces by means of thermal energy, mechanical compression, ultrasonic energy or the like. For many years, gold wires were used exclusively to attach such active devices to metallized gold surfaces. For applications in high power hybrids, a gold strip has to be employed to carry a heavy current. Because of the cost of gold, it has become necessary in recent years to seek alternatives to gold. Aluminum wires, which are relatively inexpensive, have been the most widely used alternative to gold wires. The disadvantage in using aluminum wires is that when such wires are attached to a metallized gold surface, the bond strength significantly degrades after thermal aging due to the formation of Kirkendall voids in the interface. This is especially true when the metallized surface is a dielectric.

In order to remedy this problem, palladium in relatively small amounts, for example, in the range of 1% to 3% by weight, was found to effectively inhibit the degradation of bond strengths. However, metallizations made with palladium doped thick film gold conductor compositions suffer from several other disadvantages. Thus, palladium tends to harden the gold conductor metallization, therefore requiring more energy to achieve the necessary initial contact with the aluminum wire inner connector. Also, palladium tends to significantly increase the electrical resistivity of the gold conductor. This can be a disadvantage in certain cases.

It has recently been suggested to add small amounts of silver, 0.1-4% by weight, to overcome the aluminum wire bondability problem. See U.S. Patent No. 4,230,493. While the addition of silver to the thick film gold composition does improve the aluminum wire bond strengths on alumina substrates, the improvement, particularly when the thick film gold composition is printed on a dielectric, is still lacking the desired performance characteristics.

SUMMARY OF THE INVENTION

According to the present invention, it has been found that by adding small amounts of silver/copper in a ratio of from about 90/10 to 25/75 silver to copper to a gold conductor composition, the aluminum wire bond strengths of the material improve significantly. This is especially true when the aluminum wire bond is to gold, metallized on top of a dielectric such as in a multilayer hybrid circuit. The present invention will now be described in more detail with reference to the individual components of the composition.

DETAILED DESCRIPTION OF THE INVENTION

The present invention is directed to a thick film gold composition containing small amounts of silver and copper. Generally, the composition comprises a gold material, a binder, silver and copper and an organic vehicle.

Any suitable gold material including gold powder or flakes or the mixture of both at any ratio may be used in the composition of the present invention. The gold material may also be a mixture which contains gold flake and powder, such as Engelhard A1570, A4798 or A4631, this being the presently preferred gold material such a material may be formed by either mixing the powder and the flake or forming it as a precipitate. Generally, the gold powder comprises particles approximately spherical in shape ranging in size from about 0.5 to 5.0 microns in diameter, it being understood that particles smaller and larger in size may be present. It is presently preferred to use a gold material containing powder and flakes wherein 90% of the particles are less than about 3-4 microns in diameter, 50% are less than about 1.8-2.7 microns in diameter and 10% are less than about 0.8-1.2 microns in diameter. The surface area of the particles are generally about 0.30-0.50 $m^2/g$ and more preferably about 0.35-0.45 $m^2/g$. The tap density of the gold material is generally about 5-8.5 $g/cm^3$ and more preferably about 6-8 $g/cm^3$. The gold material is generally present in an amount of from about 75 to 90% by weight, more preferably 80 to 88% by weight, and most preferably 82 to 86% by weight.

The binder for use in the composition of the present invention can be any suitable binder normally used in thick film gold compositions. The binder may include metal oxide powders, such as finely divided copper oxide, cadmium oxide and bismuth oxide, and conventional glass binders. It is presently preferred to employ a lead borosilicate based glass frit containing at least one transition metal oxide, copper oxide, bismuth oxide and cadmium oxide in trace amounts. The binder is generally present in an amount of from about 0.1 to 12% by weight and preferably in an amount of from about 0.5 to 3% by weight.

The silver/copper material of the composition of the present invention may be added to the composition in a variety of different forms. For example, it may be a coprecipitated powder of silver and copper which can then be mixed with the gold material. Alternatively, the silver/copper material may be formed by mixing together either the resinates of silver and copper, or silver oxide powder, or silver powder and copper oxide powder. It is, however, presently preferred to prepare the silver/copper material by mixing together a copper resinate such as copper ethylhexanoate and a silver paste composed of silver powder and a suitable organic vehicle. The silver powder useful in the present invention is generally spherical in shape having a diameter of from about 0.1 to 10 microns in diameter and more preferably about 0.1-10.0 microns in diameter such as Engelhard's P440 silver powder. It is presently preferred to employ a silver powder wherein 90% of the particles are less than about 5.3-9.6 microns in diameter, 50% are less than about 3.2-4.1 microns in diameter, and 10% are less than about 0.99-2.5 microns in diameter. The resulting material is then mixed on a three roll mill to form a paste which is suitable for addition to the gold composition.

The amount of the silver/copper material and the ratio of the silver to the copper in the composition of the present invention is critical in achieving the desired aluminum wire bond strengths. Generally, it is preferred to add the silver/copper material in an amount of from about 0.5 to 1.5% by weight, the percent of silver/copper referring to the amount of metal in the composition. More preferably, the amount of silver/copper is of from about 0.5 to 1.0% by weight and most preferably about 0.5% by weight. The preferred ratio of silver to copper is generally 90/10 to 25/75, more preferably 90/10 to 50/50, and most preferably 90/10 to 75/25. It is presently preferred to employ about 0.5% silver/copper in a ratio of 75/25 silver to copper, the percent representing the percent of metal present in the composition.

The organic vehicle suitable for use in the composition of the present invention comprises any of those organic vehicles conventionally employed in thick film gold conductor compositions. Such organic vehicles include solutions or dispersions of resins, such as ethyl cellulose resin. Suitable solvents or dispersion mediums should be physically compatible with the resin and the resulting solution or dispersion should be chemically inert with respect to the other components of the gold conductor composition. Anyone of the various organic liquids, with or without thickening and/or stabilizing agents and/or other additives can be used as the carrier for the organic resin. Suitable organic solvents include aliphatic alcohols, esters, glycol ethers, terpines and di-alkylphthalates. It is presently preferred to employ Staybellite resin manufactured by Hercules, butyl carbitol, terpineol and ethyl cellulose. Generally, the organic vehicle is present in an amount of from about 10 to 25% by weight and more preferably in an amount of from about 15 to 20% by weight.

According to the preferred embodiment of the present invention, the gold conductor composition is made by first mixing together a gold material containing spherical powder flakes with a binder such as a glass frit which may be in the form of a paste. Then, to that mixture is added a cadmium resinate such as cadmium 2-ethylhexoate. Thereafter, a silver powder in the form of a paste is added together with a copper resinate such as copper ethylhexanoate plus a suitable organic vehicle. The resulting mixture is mixed thoroughly and then formed into a paste on a three roll mill. The gold composition is then suitable for use in metallizing materials. Other suitable preparation techniques can, of course, be employed.

The following examples further illustrate the present invention and also provide a comparison of the performance of the composition of the present invention with performance of various compositions not within the scope of the present invention, including those only containing silver.

## EXAMPLE 1

850 g. of a gold powder/flake composition Engelhard A4631 was mixed with 31.0 g. of a lead borosilicate glass frit containing trace amounts of bismuth and copper oxide. To that mixture was added 6.0 g. of a silver ink containing 60% Ag, the remainder being an organic vehicle. Then, 20.0 g. of a cadmium resinate, was added to the mixture. Next, 7.0 g. of copper ethylhexoate was added. Finally, 42.0 g. of an organic vehicle containing 15.4% of Staybellite Resin manufactured by Hercules, 35.1% Butyl Carbitol manufactured by Textile Chemical, 35.1% Terpineol 318 manufactured by Hercules and 14.4% ethyl cellulose resin manufactured by Hercules was added. 44.0 g. of another organic vehicle containing 5% Ethyl Cellulose K-5000 manufactured by Hercules and 95% terpineol-318 was also added. All of the materials were then thoroughly mixed, loaded onto a three roll mill and then formed into a paste thereon.

## EXAMPLE 2

The gold conductor composition of this example was manufactured in a manner similar to that of Example 1 except that instead of using a mixture of silver ink and copper resinate a coprecipitated powder of silver and copper was employed.

## EXAMPLES 3-15

The gold conductor composition of each of examples 3-15 were manufactured as described in Example 1, the only difference being the ratio of silver to copper and the amount of the silver/copper material in the composition. Those ratios and amounts are shown in Table I. Examples 8, 14 and 15 are comparative examples and not part of the present invention.

TABLE I

| EX. NO | %Ag | %Cu | %COMP. | AlBOND | DEBOND | AlBOND500 | DEBOND500 | AlBOND1000 | DEBOND1000 |
|--------|-----|-----|--------|--------|--------|-----------|-----------|------------|------------|
| 1 | 75 | 25 | .5 | 9.11 | 11.13 | 4.57 | 6.36 | 4.36 | 5.94 |
|   | 75 | 25 | .5 | 11.38 | 11.76 | 3.07 | 3.98 | 2.80 | 3.86 |
| 2 | 75 | 25 | 1 | 8.81 | 10.55 | 4.75 | 6.12 | 4.26 | 5.78 |
|   | 75 | 25 | 1 | 10.77 | 11.16 | 3.85 | 5.46 | 1.91 | 4.63 |
| 3 | 25 | 75 | .5 | 8.73 | 11.86 | 4.30 | 6.47 | 4.12 | 5.68 |
|   | 25 | 75 | .5 | 9.27 | 11.44 | 5.28 | 5.86 | 3.72 | 5.16 |
| 4 | 50 | 50 | 1 | 6.77 | 9.13 | 3.71 | 4.98 | 3.33 | 4.83 |
|   | 50 | 50 | 1 | 9.15 | 10.24 | 4.69 | 4.62 | 4.57 | 5.04 |
| 5 | 25 | 75 | 1.5 | 6.72 | 8.27 | 3.61 | 3.32 | 3.32 | 2.96 |
|   | 25 | 75 | 1.5 | 9.13 | 9.26 | 3.79 | 2.91 | 3.82 | 2.41 |
| 6 | 75 | 25 | 1.5 | 9.23 | 9.42 | 4.93 | 4.86 | 4.64 | 3.72 |
|   | 75 | 25 | 1.5 | 7.53 | 8.00 | 3.56 | 4.85 | 2.93 | 3.91 |
| 7 | 75 | 25 | .5 | 8.92 | 10.21 | 4.50 | 4.80 | 4.30 | 3.47 |
|   | 75 | 25 | .5 | 8.90 | 8.97 | 4.12 | 4.61 | 4.25 | 3.62 |
| 8 | 100 |   | .75 | 9.43 | 7.92 | 4.57 | 3.71 | 4.04 | 3.06 |
|   | 100 |   | .75 | 10.08 | 9.54 | 4.90 | 4.07 | 4.26 | 3.00 |
| 9 | 50 | 50 | 1 | 7.73 | 7.67 | 4.60 | 4.11 | 4.88 | 4.02 |
|   | 50 | 50 | 1 | 9.28 | 8.91 | 5.02 | 4.80 | 5.03 | 4.10 |
| 10 | 25 | 75 | .5 | 5.43 | 6.57 | 2.25 | 2.05 | 2.74 | 1.98 |
|    | 25 | 75 | .5 | 7.77 | 7.32 | 3.73 | 2.54 | 3.44 | 2.72 |
| 11 | 75 | 25 | 1.5 | 7.04 | 6.03 | 4.34 | 3.74 | 3.36 | 3.25 |
|    | 75 | 25 | 1.5 | 9.02 | 8.43 | 4.08 | 3.89 | 4.20 | 3.43 |
| 12 | 50 | 50 | 1 | 8.45 | 8.48 | 4.67 | 4.07 | 4.57 | 4.13 |
|    | 50 | 50 | 1 | 8.07 | 8.55 | 4.85 | 3.67 | 4.40 | 2.70 |
| 13 | 90 | 10 | .5 | 8.03 | 7.80 | 5.03 | 4.80 | 4.43 | 3.57 |
|    | 90 | 10 | .5 |  |  | 4.53 | 3.23 | 3.40 | 3.27 |
| 14 | 90 | 10 | .3 |  |  | 2.07 | 2.57 |  |  |
| 15 | 90 | 10 | .1 |  |  | 2.97 | 2.17 |  |  |

ALBOND means the aluminum wire bond strength of an unaged metallized substrate.
DEBOND means the aluminum wire bond strength of a metallized dielectric layer.

4

ALBOND500 means the aluminum wire bond strength of a metallized substrate after aging for 500 hours at 100°C.

DEBOND500 means the aluminum wire bond strength of a metallized dielectric layer after aging for 500 hours at 150°C.

ALBOND1000 means the aluminum wire bond strength of a metallized substrate after aging for 1000 hours at 150°C.

DEBOND1000 means the aluminum wire bond strength of a metallized dielectric layer after aging for 1000 hours at 150°C.

To perform the bond tests recited in Table I, the gold conductor compositions were printed on either a 96% alumina substrate or over a dielectric material which was printed on a 96% alumina substrate. Kulick and Soffa Wedge Bonder 484 was used for bonding 1 mil gold and aluminum wire. For aluminum wire, the settings of the wire bonder were 20 g. of force, 2.0 power and 1.5 milliseconds. 150 bonds were made for each data point reported. All bonds were pulled to failure using a Unitek Micropull III. Table I shows the aluminum wire bond strengths in grams under various conditions for the various compositions tested. Each composition was tested after metallization and a single firing and after metallization and 15 firings. Each firing was performed using a belt furnace with a 60 minute cycle and a peak temperature of 850°C for 10 minutes. The multiple firing data is the second line of data of each of the Examples in Table I.

## Claims

1. A gold conductor composition comprising a gold material, a binder, an organic vehicle and silver and copper in a ratio of from about 90/10 to 25/75 silver to copper, said silver and copper being present in an amount of about 0.5 to 1.5% by weight of the composition.

2. The composition according to claim 1, wherein the gold material is present in an amount of about 75 to 90% by weight of the composition.

3. The composition according to claim 2, wherein the gold material is in the form of a mixture of powder and flakes.

4. The composition according to claim 1, wherein the silver and copper are in the form of a coprecipitated powder.

5. The composition according to claim 1, wherein the silver is in the form of an ink and the copper is in the form of a resinate.

6. The composition according to claim 1, wherein the copper resinate is copper ethylhexanoate.

7. The composition according to claim 1, wherein the gold material is present in an amount of about 82 to 86% by weight of the composition.

8. The composition according to claim 1, wherein the binder is a glass frit based composition.

9. A gold conductor composition comprising a gold material in an amount of about 75 to 90% by weight of the composition, a binder in an amount of about silver and copper in a ratio of about 90/10 to 25/75 silver to copper and in an amount of about 0.5 to 1.5% by weight of the composition, and an organic vehicle.

10. The composition according to claim 1, wherein the ratio of silver to copper is about 90/10 to 75/25.

11. The composition according to claim 10, wherein the amount of silver and copper is about 0.5-1.0% by weight of the composition.

12. A substrate metallized with the composition of claim 1.

13. The substrate of claim 12, wherein in the substrate is a dielectric.